# EUROPÄISCHE PATENTSCHRIFT

(11) **EP 1 700 169 B1**
(45) Veröffentlichungstag und Bekanntmachung des Hinweises auf die Patenterteilung: **20.08.2008**
(21) Anmeldenummer: 04803270.0
(22) Anmeldetag: 25.11.2004
(51) Int. Cl.: G03F 9/00

(54) **DIREKTE JUSTIERUNG IN MASKALIGNERN**
DIRECT ALIGNMENT IN MASK ALIGNERS
ALIGNEMENT DIRECT DANS DES DISPOSITIFS D'ALIGNEMENT DE MASQUE

(30) Priorität: 28.11.2003 DE 10355681
(43) Veröffentlichungstag der Anmeldung: 13.09.2006
(73) Patentinhaber: Süss MicroTec Lithography GmbH, 85748 Garching (DE)
(72) Erfinder: HÜLSMANN, Thomas, Dr., 85748 Garching (DE); HAENEL, Wolfgang, 85386 Eching (DE); STIEVENARD, Philippe, F-59300 Valenciennes (FR)
(74) Vertreter: Vossius & Partner
(86) Internationale Anmeldenummer: PCT/EP2004/013380
(87) Internationale Veröffentlichungsnummer: WO 2005/052695

(56) Entgegenhaltungen:
- EP-A- 0 556 669
- US-A- 4 615 621
- US-A- 4 798 470
- US-B1- 6 252 649
- US-B1- 6 381 002
- PATENT ABSTRACTS OF JAPAN Bd. 018, Nr. 556 (E-1620), 24. Oktober 1994 (1994-10-24) & JP 06 204109 A (USHIO INC), 22. Juli 1994 (1994-07-22)

## Beschreibung

Die Erfindung betrifft ein Verfahren zum Justieren bzw. Ausrichten zweier flächiger Substrate, beispielsweise einer Maske zu einem Wafer oder zweier Wafer zueinander.

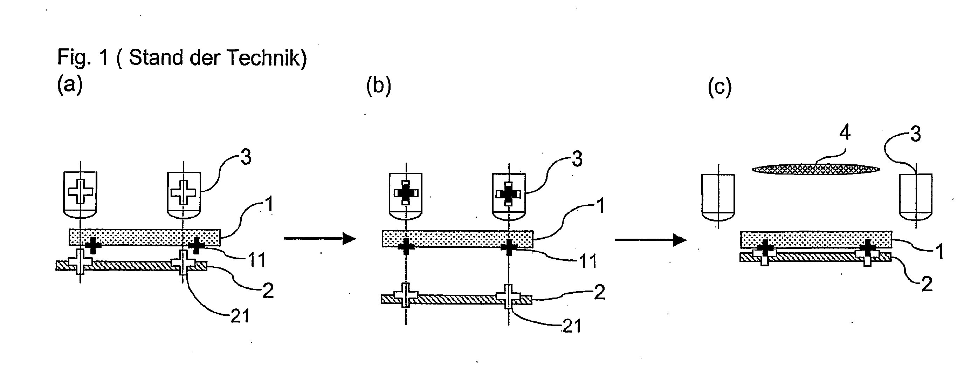

Im Rahmen der Fertigung von Halbleiterbauelementen müssen vor dem Belichten eines Substrates bzw. eines Wafers durch eine Maske zunächst die Maske und der Wafer zueinander ausgerichtet bzw. justiert werden. Dies geschieht üblicherweise in einem Maskaligner bzw. einer Maskenpositioniereinrichtung. Sowohl die Maske als auch der Wafer weisen Justiermarken auf, mit deren Hilfe die Maske zum Wafer positioniert werden kann. In einem bekannten Justierverfahren, das in Fig. 1 schematisch dargestellt ist, werden die Justiermarken 11 bzw. 21 auf der Maske 1 und dem Wafer 2 durch Mikroskope 3 beobachtet. In diesem bekannten Verfahren wird zunächst die Maske 1 parallel zur Oberfläche des Wafers 2 verfahren, damit die Justiermarken 21, die in der Figur als Justierkreuze dargestellt sind, durch die Mikroskope 3 beobachtet werden können (Fig. 1a). Die Maske wird hierbei entweder nur so weit in das sogenannte "Clearfield" verfahren, daß die Sicht auf die Justiermarken 21 des Wafers 2 durch die Mikroskope 3 freigegeben ist, oder vollständig aus dem Objektfeld des Mikroskops 3 herausgefahren. Der letztgenannte Fall wird auch als "Large Clearfield"-Justierung bezeichnet. Während sich die Maske 1 im Clearfield bzw. Large Clearfield befindet, werden die Mikroskope bzgl. den Justiermarken 21 auf dem Wafer 2 zentriert und die Position oder das Bild der Justiermarken 21 gespeichert.

In einem nächsten Schritt wird der Wafer 2 gegebenenfalls in Richtung der optischen Achse des Mikroskops 3, also senkrecht zur Ebene des Wafers 2 verschoben und die Maske 1 in eine Position gebracht, in der die Justiermarken 11 auf der Maske 1 durch die Mikroskope 3 beobachtet werden können (Fig. 1b). Die Positionen der Justiermarken 11 der Maske 1 werden mit den gespeicherten Positionen der Justiermarken 21 des Wafers 2 zur Deckung gebracht, und so die Maske 1 positioniert. Daher wird dieses Justierverfahren auch als indirekte Justierung bezeichnet.

Anschließend wird der Wafer in den Belichtungsabstand, den sogenannten "Exposure Gap" zurückbewegt, die Mikroskope 3 aus dem Bereich über der Maske 1 entfernt und der Wafer durch eine Belichtungseinrichtung 4 durch die Maske 1 belichtet (Fig. 1c). Hierbei kann der Belichtungsabstand null sein, d.h. die Belichtung des Wafers findet in Kontakt mit der Maske statt.

Das in Fig. 1 gezeigte Beispiel zeigt das sogenannte top side alignment-(TSA-)Verfahren, in dem sich die Justiermikroskope 3 und die Belichtungseinrichtung 4 auf derselben Seite über der Maske 1 befinden. Im Fall des sogenannten bottom side alignment-(BSA-)Verfahrens befinden sich die Justiermikroskope 3 auf gegenüberliegenden Seiten der zu positionierenden Wafer, so daß vor dem Einlegen des Wafers die Justiermarken 11 der Maske 1 gespeichert werden müssen, und dann der Wafer 2 zum gespeicherten Bild justiert wird. Dieses Verfahren wird außerdem bei der Infrarotjustage in der Lithographie verwendet, bei der durch Verwendung von IR-Licht die Justiermarken auf der Maske durch ein Silizium-Substrat hindurch beobachtet werden können. Das Problem des genauen Ausrichtens zweier flächiger Substrate zueinander stellt sich auch im Falle des Bondens zweier Substrate. Auch hier wird das oben beschriebene Justierverfahren verwendet, beispielsweise beim Bonden eines Glas- zu einem Siliziumwafer oder beim Bonden zweier Siliziumwafer mit Hilfe von Infrarotjustage. Die Grundidee des oben beschriebenen Justierverfahrens ist in der EP-B-0 556 669 beschrieben.

Ein Nachteil dieses Verfahrens besteht darin, daß sich die Position des Substrats bzw. des Wafers durch das Verschieben in Richtung der optischen Achse des Mikroskops zur Beobachtung der Justiermarken der Maske verändert und so zu Ungenauigkeiten in der Justierung führen kann. Zusätzlich können sich durch das Verschieben der Maske in das Clearfield das Substrat bzw. die Justiermikroskope bewegen. Weiterhin muß das Mikroskop zwischen der Beobachtung der Justiermarken des Substrats und der Beobachtung der Justiermarken der Maske umfokussiert werden, da sich Maske und Substrat nicht im gleichen Abstand zum Mikroskop befinden. Auch diese Umfokussierung kann zu Ungenauigkeiten führen. Um die Umfokussierung des Mikroskops zu vermeiden, könnte alternativ auch der Abstand zwischen Mikroskop und Maske während des Justiervorgangs verändert werden, wobei auch diese Bewegungen die Justiergenauigkeit negativ beeinflussen können.

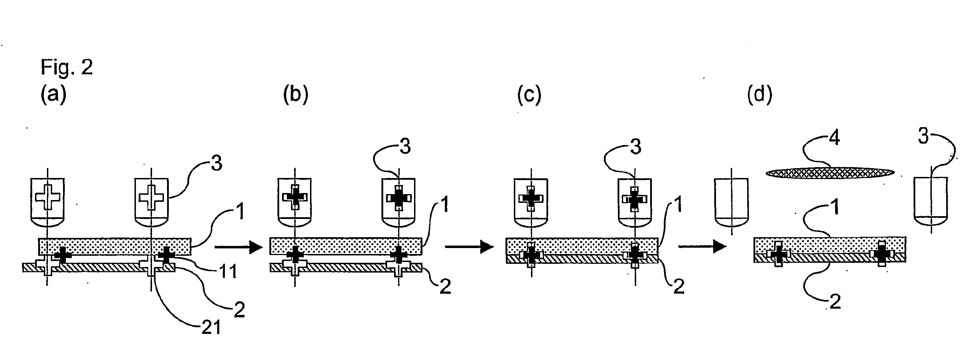

Um die Genauigkeit der Justierung zu erhöhen, wird in einem verbesserten Verfahren die Position der Maske zum Wafer vor der Belichtung nachgemessen bzw. überprüft (Fig. 2). Dieser Schritt ist schematisch in Fig. 2c gezeigt. Hierzu wird der Wafer 2 nach der Positionierung der Maske 1 mit dieser in Belichtungsabstand oder in Kontakt gebracht. Bei genügend kleinem Belichtungsabstand können somit beide gleichzeiting in Fokus gebracht und damit bestimmt werden, ob sich die beiden Justiermarken in Deckung befinden. Wird in diesem Schritt ein Justierfehler beobachtet, der größer als eine vorbestimmte Mindestgenauigkeit ist, wird das Verfahren wie oben mit Bezug auf Fig. 1 beschrieben wiederholt.

Nachteilig jedoch ist, daß die letztgenannte Methode sehr zeitaufwendig ist, da bei Feststellen einer ungenauen Justierung das gesamte Justierverfahren wiederholt wird. Weiterhin kann das Heraus- und Hereinfahren der Maske zu Verunreinigungen von Maske und Wafer führen. Durch die Kontaktierung besteht außerdem die Gefahr der Beschädigung der Maske bzw. des Wafers.

In der US-A-4 595 295 ist ein Aligment-System für Nah-Abstand-Lithographie beschrieben. Die US-A-4 794 648 beschreibt einen Mask-Aligner mit einer Vorrichtung zum Erfassen der Wafer-Position.

Der Erfindung liegt daher die Aufgabe zugrunde, ein verbessertes Verfahren zum gegenseitigen Ausrichten zweier flächiger Substrate, beispielsweise einer Maske zu einem Wafer oder zweier Wafer zueinander, bereitzustellen. Insbesondere soll das erfindungsgemäße Verfahren die oben beschriebenen Probleme lösen und die Genauigkeit der Justierung bzw. der Ausrichtung verbessern.

Die Aufgabe wird durch die in den Ansprüchen enthaltenen Merkmale gelöst.

Die vorliegende Erfindung basiert auf dem Grundgedanken, in einem zusätzlichen Schritt die Position der beiden Substrate zueinander zu überprüfen bzw. zu korrigieren, während sich die Substrate vorzugsweise senkrecht zur Oberfläche der Substrate in einem Abstand zueinander befinden. Nach dem indirekten Justieren gemäß dem oben beschriebenen bekannten Verfahren werden hierzu die Justiermarken beider zueinander auszurichtenden Substrate im wesentlichen gleichzeitig optisch z. B. mit einem Justiermikroskop beobachtet. Die beiden Substrate können beispielsweise zwei Wafer oder eine Maske und ein Wafer sein.

Der Abstand zwischen den beiden Substraten entspricht während dem Beobachten vorzugsweise dem Abstand, bei dem die nachfolgende Belichtung des Wafers durch die Maske durchgeführt wird. Während des Beobachtens können die beiden Substrate auch in Kontakt miteinander sein (Kontakt-Belichtung). In diesem Fall muß jedoch die gegebenenfalls notwendige Korrektur der Position der Substrate in einem Abstand der Substrate voneinander stattfinden. Diese Justierung wird im folgenden auch als direkte Justierung bezeichnet.

Für die direkte Justierung müssen die beiden Justiermarken gleichzeitig sichtbar und unterscheidbar sein. Aktuelle Bilderkennungsverfahren, z.B. solche mit Kantenerkennung, sind dazu in der Lage. Um beide Justiermarken gleichzeitig beobachten zu können, wird das Justiermikroskop bevorzugt so eingestellt, daß die Fokusebene etwa in der Mitte zwischen den beiden Substraten liegt. Dadurch sind die Bilder der beiden Justiermarken leicht unscharf. Bei den üblichen Belichtungsabständen von etwa 20 bis 50 µm in Kombination mit modernen Bildverarbeitungsprogrammen, die in der Lage sind, auch leicht unscharfe Bilder mit höchster Genauigkeit verarbeiten zu können, führt dies jedoch zu keiner Einschränkung der Genauigkeit der Justierung.

Ein Vorteil des erfindungsgemäßen Verfahrens besteht darin, daß die Justierung bzw. Ausrichtung der Maske zum Substrat in der Anordnung überprüft bzw. durchgeführt wird, in der auch die Belichtung des Substrats stattfindet. Es sind also im Gegensatz zu den herkömmlichen Verfahren keinerlei Bewegungen der auszurichtenden Substrate nach der Justierung erforderlich, die die Justierung verfälschen könnten. Weiterhin ist es im Gegensatz zu der oben beschriebenen Überprüfung der Justierung in Kontakt gemäß dem erfindungsgemäßen Verfahren möglich, die Position der Maske bzw. des Substrats während der direkten Justierung zu korrigieren. Dadurch entfällt die zeitaufwendige Wiederholung des Justiervorgangs im Falle eines Feststellens eines Justierfehlers.

Weiterhin kann das erfindungsgemäße direkte Justierverfahren auch mit der Messung im Kontakt kombiniert werden, so daß das Verfahren nicht nur für Belichtungen in einem geringen Belichtungsabstand, sogenannten Proximity-Belichtungen, geeignet ist, sondern auch für solche im Kontakt oder für die Anordnung zweier Substrate beim Bonden anwendbar ist.

Die Erfindung wird nachstehend mit Bezug auf die anliegenden Zeichnungen näher erläutert. Es zeigen:
- Fig. 1: schematisch die Schritte des herkömmlichen Verfahrens zum Justieren einer Maske zu einem Substrat,
- Fig. 2: die Verfahrensschritte eines verbesserten Verfahrens zur Justierung einer Maske zu einem Substrat mit dem zusätzlichen Schritt des Messens in Kontakt oder im Belichtungsabstand,
- Fig. 3: die Schritte eines Verfahrens zur Justierung einer Maske zu einem Substrat unter Verwendung der erfindungsgemäßen direkten Justierung,
- Fig. 4: die Schritte eines Verfahrens zur Justierung einer Maske zu einem Substrat, wobei die erfindungsgemäße direkte Justierung mit der Messung in Kontakt kombiniert wird,
- Fig. 5: schematisch die Justiermarken im Falle einer Dunkelfeldmaske (Fig. 5a) und einer Hellfeldmaske (Fig. 5b).

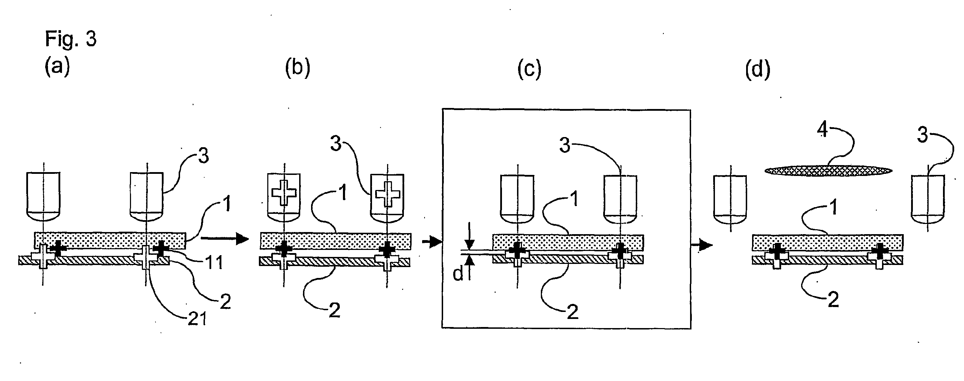

Fig. 3 zeigt schematisch die Verfahrensschritte des erfindungsgemäßen Verfahrens zum Justieren zweier flächiger Substrate am Beispiel der Ausrichtung einer Maske 1 zu einem Substrat bzw. Wafer 2. Die ersten beiden Schritte der Mikroskopzentrierung bzw.

Speicherung der Positionen der Justiermarken 21 des Wafers 2 (Fig. 3a) und der Justierung der Maske mit Hilfe der Position der Justiermarken der Maske 1 und der gespeicherten Positionen der Justiermarke 21 des Wafers 2 (Fig. 3b) entsprechen den Schritten des herkömmlichen Verfahrens, das oben mit Bezug auf Fig. 1 beschrieben wurde.

Nach der Justierung der Maske 1 wird gemäß der vorliegenden Erfindung der Wafer 2 in den Belichtungsabstand d gefahren und die Positionen der Justiermarken 11 und 21 der Maske 1 bzw. des Wafers 2 optisch durch das Mikroskop 3 bestimmt. Eventuelle Justierfehler können direkt in diesem Schritt korrigiert werden. Anschließend werden wie im herkömmlichen Verfahren die Mikroskope entfernt und der Wafer durch die Maske belichtet. Die Belichtung erfolgt gemäß der vorliegenden Erfindung ohne die Anordnung der Maske 1 und des Wafers 2 nach der endgültigen Justierung zu verändern. Somit ist die einzige Bewegung, die in dem System zwischen der Justierung und der Belichtung erfolgt und somit die Genauigkeit der Justierung beeinflussen könnte, die Entfernung der Mikroskope. Die Genauigkeit der Justierung wird also deutlich erhöht.

Das erfindungsgemäße Verfahren kann nicht nur in der eben beschriebenen top side alignment-Anordnung, sondern auch in der bottom side alignment-Anordnung durchgeführt werden. In dieser Anordnung entfällt zusätzlich die Entfernung der Mikroskope, was wiederum die Genauigkeit der Justierung erhöht.

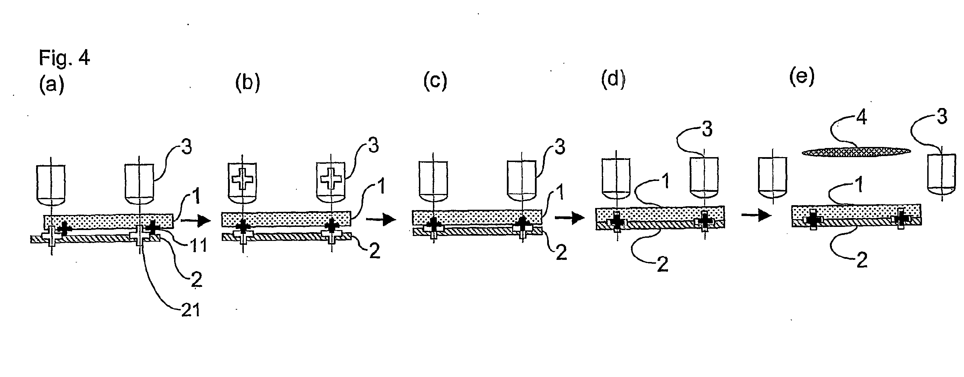

Soll die Belichtung des Wafers durch die Maske nicht in einem gewissen Abstand der Maske vom Wafer, sondern in Kontakt erfolgen, kann die erfindungsgemäße direkte Justierung auch mit der oben mit Bezug auf Fig. 2 beschriebenen Messung in Kontakt kombiniert werden. Hierzu folgt auf die direkte Justierung der Maske 1 zum Wafer 2 (Fig. 4c), in der sich Maske 1 und Wafer 2 in einem gewissen Abstand voneinander befinden, damit die Position der Maske 1 während der direkten Justierung korrigiert werden kann, ein zusätzlicher Schritt, in dem der Wafer 2 in Kontakt mit der Maske 1 gebracht wird. In dieser Anordnung kann die Position der Maske 1 bzgl. zum Wafer 2 nochmals direkt überprüft werden und, falls hierbei Justierfehler festgestellt werden sollten, die direkte Justierung wiederholt werden.

Die eben beschriebene Kombination der direkten Justierung mit der Messung in Kontakt kann auch zum Justieren zweier Wafer zueinander verwendet werden. Sollen beispielsweise ein Glas- und ein Siliziumwafer gebondet werden, kann die Justiermarke des Siliziumwafers durch den Glaswafer hindurch optisch im sichtbaren Bereich beobachtet werden. Sollen zwei Siliciumwafer zueinander ausgerichtet werden, wird die sogenannte Infrarotjustage verwendet, bei der die Justiermarken des einen Wafers durch den anderen Wafer hindurch mittels Infrarotlicht beobachtet werden.

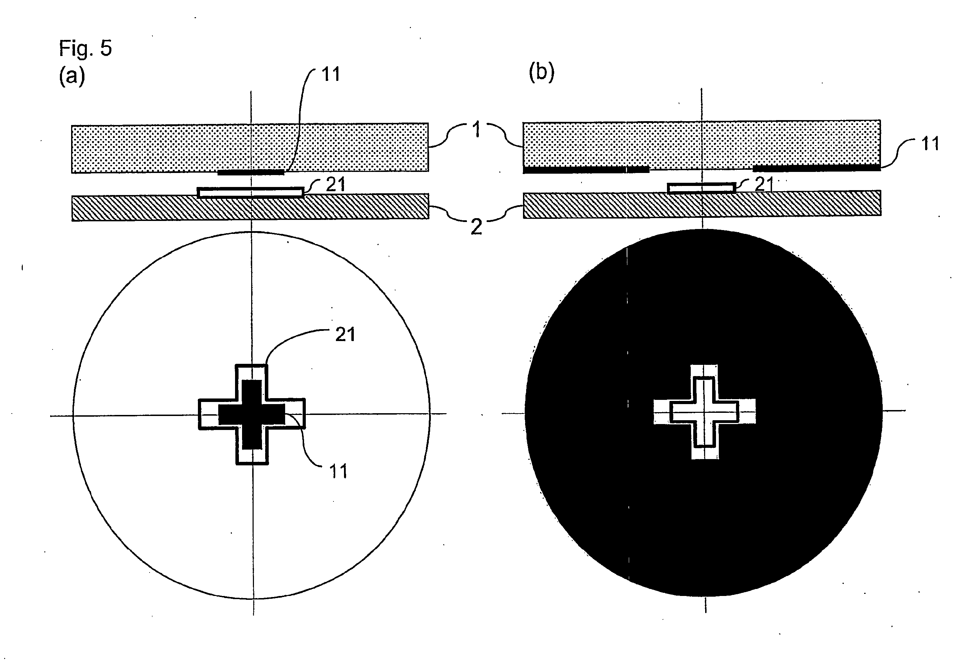

Für die direkte Justierung müssen die Justiermarken sowohl der Maske als auch des Wafers gleichzeitig sichtbar sein. In Fig. 5a ist die für eine Hellfeld-Maske bzw. positive Maske gezeigt. Die Justiermarke 21 des Wafers 2, die in dem gezeigten Beispiel als Justierkreuz ausgeführt ist, ist geringfügig größer als die Marke 11 der darüberliegenden Maske 1. Dieser Überstand sollte vorzugsweise mindestens 4µm betragen. Wird im Gegensatz zum gezeigten Beispiel keine positive Maske sondern eine negative Maske verwendet, d.h. eine Maske, in der die Marke als Aussparung in einer ansonsten bedeckten Fläche ausgebildet ist, wie es in Fig. 5b gezeigt ist, muß die Marke der Maske größer sein als die des Wafers. Jedoch sollte auch in diesem Fall der Überstand vorzugsweise mindestens etwa 4µm betragen.

Durch den zusätzlichen Verfahrensschritt der direkten Justierung gemäß der vorliegenden Erfindung wird die Zeit, die zum Ausrichten bzw. Justieren der Maske zum Wafer benötigt wird, gegenüber der herkömmlichen Methode geringfügig erhöht. So beträgt die Zeit, die für die Justierung und Belichtung eines Wafers benötigt wird, etwa 1 Minute. Da in modernen Maskalignern zwei Wafer gleichzeitig bearbeitet werden, beträgt der Durchsatz zwei Wafer pro Minute. Im Vergleich zu dem herkömmlichen Verfahren, in dem die Justierung durch Nachmessen im Kontakt überprüft wird, bietet das Verfahren gemäß der vorliegenden Erfindung einen Geschwindigkeitsvorteil, da bei Feststellen eines Justierfehlers nicht der gesamte Justiervorgang wiederholt werden muß.

Ferner können mit dem erfindungsgemäßen Verfahren deutlich größere Genauigkeiten bei der Justierung erzielt werden. Während mit herkömmlichen Justierverfahren Genauigkeiten von einigen µm erreicht werden könnten, wurden mit dem Verfahren gemäß der vorliegenden Erfindung Genauigkeiten unter 0,5µm erzielt.

## Patentansprüche

1. Verfahren zum Justieren zweier flächiger im Wesentlichen parallel zueinander angeordneter Substrate (1, 2) zueinander, die jeweils mindestens eine Justiermarke (11 bzw. 21) zum gegenseitigen Ausrichten aufweisen, mit den folgenden Verfahrensschritten:
(1) einem ersten Justierschritt durch
(1.1) optisches Bestimmen der Position der Justiermarke (21) des ersten Substrates (2),
(1.2) Speichern der Position des ersten Substrats (2) und
(1.3) Verschieben des zweiten Substrats (1) parallel zum ersten Substrat (2), so dass die Justiermarke (11) des zweiten Substrats (1) mit der gespeicherten Position der Justiermarke (21) des ersten Substrats (2) in Deckung ist, und
(2) einem zweiten Justierschritt durch
(2.1) im wesentlichen gleichzeitiges Beobachten der Position der beiden Justiermarken (11, 21) der beiden Substrate (1,2) und
(2.2) Ausrichten der Justiermarken (11, 21) der beiden Substrate (1,2) zueinander durch eine Relativbewegung der beiden Substrate (1,2) in der Substratebene.

2. Verfahren nach Anspruch 1, wobei beide Substrate jeweils Wafer sind.

3. Verfahren nach Anspruch 1, wobei das eine Substrat (1) eine Maske und das andere Substrat (2) ein Wafer ist.

4. Verfahren nach einem der vorstehenden Ansprüche, wobei im Verfahrensschritt (2.1) der Parallelabstand zwischen den beiden Substraten etwa 0 µm bis etwa 100 µm beträgt.

5. Verfahren nach einem der vorstehenden Ansprüche, wobei im Verfahrensschritt (2.2) der Parallelabstand zwischen den beiden Substraten größer oder gleich dem Parallelabstand zwischen den beiden Substraten im Verfahrensschritt (2.1) ist.

6. Verfahren nach einem der vorstehenden Ansprüche, wobei die Justiermarken (11, 12) mit einem Justiermikroskop (3) beobachtet werden.

7. Verfahren nach Anspruch 6, wobei die Fokusebene des Justiermikroskops (3) zwischen den beiden Substraten (1, 2) liegt.

8. Verfahren nach einem der vorstehenden Ansprüche, wobei die Positionen der Justiermarken (11, 21) durch eine automatische Bilderkennung bestimmt werden.

9. Verfahren nach einem der Ansprüche 3 bis 8, wobei im Verfahrensschritt (2) der Parallelabstand der beiden Substrate dem Abstand entspricht, bei dem die nachfolgende Belichtung des Wafers durch die Maske durchgeführt wird.

## Claims

1. A method for aligning two flat substrates (1, 2) being arranged essentially parallel with each other and each having at least one alignment mark (11, 21, respectively) for mutual alignment, the method comprising the following method steps:
(1) a first alignment step including
(1.1) optically determining the position of the alignment mark (21) of the first substrate (2),
(1.2) storing the position of the first substrate (2) and
(1.3) moving the second substrate (1) parallel with respect to the first substrate (2) so that the alignment mark (11) of the second substrate (1) corresponds with the stored position of the alignment mark (21) of the first substrate (2), and
(2) a second alignment step including
(2.1) essentially simultaneously observing the position of the two alignment marks (11, 21) of the two substrates (1, 2) and
(2.2) aligning the alignment marks (11, 21) of the two substrates (1, 2) with each other by means of a relative movement of the two substrates (1, 2) in the substrate plane.

2. The method according to claim 1, wherein both substrates are wafers.

3. The method according to claim 1, wherein one substrate (1) is a mask and the other substrate (2) is a wafer.

4. The method according to any one of the preceding claims, wherein in method step (2.1) the parallel distance between the two substrates is about 0 µm to about 100 µm.

5. The method according to any one of the preceding claims, wherein in method step (2.2) the parallel distance between the two substrates is larger than or equal to the parallel distance between the two substrates in method step (2.1).

6. The method according to any one of the preceding claims, wherein the alignment marks (11, 12) are observed by means of an alignment microscope (3).

7. The method according to claim 6, wherein the focal plane of the alignment microscope (3) lies between the two substrates (1, 2).

8. The method according to any one of the preceding claims, wherein the positions of the alignment marks (11, 21) are determined by an automatic image recognition.

9. The method according to any one of claims 3 to 8, wherein in method step (2) the parallel distance between the two substrates corresponds to the distance at which the subsequent exposure of the wafer through the mask is carried out.

## Revendications

1. Procédé d'alignement de deux substrats (1, 2) plans agencés de manière essentiellement parallèle l'un par rapport à l'autre, qui présentent respectivement au moins une marque d'alignement (11 ou 21) pour l'orientation mutuelle, comprenant les étapes de procédé suivantes :
(1) une première étape d'alignement par
(1.1) la détermination optique de la position de la marque d'alignement (21) du premier substrat (2),
(1.2) l'enregistrement de la position du premier substrat (2) et
(1.3) le décalage du second substrat (1) parallèlement au premier substrat (2), de telle sorte que la marque d'alignement (11) du second substrat (1) soit superposée avec la position enregistrée de la marque d'alignement (21) du premier substrat (2), et
(2) une seconde étape d'alignement par
(2.1) la surveillance essentiellement simultanée de la position des deux marques d'alignement (11, 21) des deux substrats (1, 2) et
(2.2) l'alignement des marques d'alignement (11, 21) des deux substrats (1, 2) l'une par rapport à l'autre au moyen d'un déplacement relatif des deux substrats (1, 2) dans le plan de substrat.

2. Procédé selon la revendication 1, dans lequel les deux substrats sont respectivement des galettes.

3. Procédé selon la revendication 1, dans lequel le premier substrat (1) est un masque et l'autre substrat (2) est une galette.

4. Procédé selon l'une quelconque des revendications précédentes, dans lequel à l'étape de procédé (2.1), la distance parallèle entre les deux substrats atteint environ 0 µm à environ 100 µm.

5. Procédé selon l'une quelconque des revendications précédentes, dans lequel à l'étape de procédé (2.2), la distance parallèle entre les deux substrats est supérieure ou égale à la distance parallèle entre les deux substrats à l'étape de procédé (2.1).

6. Procédé selon l'une quelconque des revendications précédentes, dans lequel les marques d'alignement (11, 12) sont surveillées au moyen d'un microscope d'alignement (3).

7. Procédé selon la revendication 6, dans lequel le plan focal du microscope d'alignement (3) se trouve entre les deux substrats (1, 2).

8. Procédé selon l'une quelconque des revendications précédentes, dans lequel les positions des marques d'alignement (11, 21) sont déterminées par une analyse d'image automatique.

9. Procédé selon l'une quelconque des revendications 3 à 8, dans lequel à l'étape de procédé (2), la distance parallèle entre les deux substrats correspond à l'écart dans lequel l'exposition suivante de la galette est réalisée à travers le masque.
